# EUROPEAN PATENT SPECIFICATION

(11) **EP 2 298 712 B1**
(45) Date of publication and mention of the grant of the patent: **01.10.2014**
(21) Application number: 09794308.8
(22) Date of filing: 23.06.2009
(51) Int. Cl.: C04B 35/00, C04B 35/50, C23C 14/34

(54) **SPUTTERING TARGET COMPRISING THE SINTERED OBJECT, PROCESS FOR PRODUCING THE SINTERED OBJECT, AND PROCESS FOR PRODUCING SPUTTERING TARGET COMPRISING THE SINTERED OBJECT**
SPUTTERING-TARGET MIT DEM GESINTERTEN OBJEKT, VERFAHREN ZUR HERSTELLUNG DES GESINTERTEN OBJEKTS AUF LANTHANOXIDBASIS SOWIE VERFAHREN ZUR HERSTELLUNG DES SPUTTERING-TARGETS MIT DEM GESINTERTEN OBJEKT
CIBLE DE PULVÉRISATION COMPRENANT L'OBJET FRITTÉ, PROCÉDÉ POUR PRODUIRE L'OBJET FRITTÉ, ET PROCÉDÉ POUR PRODUIRE UNE CIBLE DE PULVÉRISATION COMPRENANT L'OBJET FRITTÉ

(30) Priority: 07.07.2008 JP 2008176461
(43) Date of publication of application: 23.03.2011
(73) Proprietor: JX Nippon Mining & Metals Corporation, Tokyo 100-8164 (JP)
(72) Inventor: SATOH Kazuyuki, Kitaibaraki-shi Ibaraki 319-1535 (JP); KOIDO Yoshimasa, Kitaibaraki-shi Ibaraki 319-1535 (JP)
(74) Representative: Hoarton, Lloyd Douglas Charles
(86) International application number: PCT/JP2009/061353
(87) International publication number: WO 2010/004862

(56) References cited:
- WO-A1-2006/025350
- WO-A1-2007/142333
- JP-A- 4 164 858
- JP-A- 2000 001 362
- JP-A- 2001 342 056
- JP-A- 2004 327 210
- JP-A- 2004 339 035
- JP-A- 2007 334 357
- JP-T- 2001 505 620
- US-A1- 2008 233 406
- US-A1- 2010 019 357
- BYOUNG HUN LEE ET AL: "Metal Electrode/High-<formula formulatype="inline"><tex>$k$</tex></formu la> Dielectric Gate-Stack Technology for Power Management", IEEE TRANSACTIONS ON ELECTRON DEVICES, vol. 55, no. 1, 1 January 2008 (2008-01-01), pages 8-20, XP55013589, ISSN: 0018-9383, DOI: 10.1109/TED.2007.911044
- YAMING JI ET AL.: 'Fabrication of transparent La2Hf207 ceramics from combustion synthesized powders' MATERIALS RESEARCH BULLETIN vol. 40, no. ISS.3, 08 March 2005, pages 553 - 559, XP004753215

## Description

### TECHNICAL FIELD

The present invention relates to an oxide sintered compact composed of the oxides of lanthanum (La) and hafnium (Hf), a sputtering target composed of the sintered compact, a method of producing the sintered compact, and a method of producing the sintered compact sputtering target.

### BACKGROUND ART

In recent years, thinning of a gate insulator film in the next-generation MOSFET is being demanded, but with the SiO₂ that has been conventionally used as the gate insulator film, the leak current will increase due to the tunnel effect, and normal operation is becoming difficult.

Thus, as a substitute for the SiO₂ described above, so-called high-k materials such as HfO₂, ZrO₂, Al₂O₃ and La₂O₃ with high dielectric constant, high thermal stability, and high energy barrier against the holes and electrons in the silicon have been proposed.

Among the foregoing materials, HfO₂-based materials are considered to be highly promising, and there have been research papers regarding their use as a gate insulting film in the next-generation MOSFET. Recently, there have been reports that improvement in properties such as lowering the threshold voltage can be achieved by using, in combination, HfO-based high-k material and lanthanum oxide (La₂O₃), and lanthanum is a material that is noticeable as an electronic material.

Lanthanum (La) is one of the rare earth elements, and is a mineral resource that is contained in the earth's crust as a mixed composite oxide. Rare-earth elements are called "rare-earth" elements because they are separated from relatively rare minerals, but they are not that rare in light of the overall earth's crust.

Lanthanum is a white metal having an atomic number of 57 and an atomic weight of 138.9, and comprises a double hexagonal close-packed structure at normal temperature. Lanthanum has a melting point of 921°C, boiling point of 3500°C, and density of 6.15 g/cm³, its surface is oxidized in the atmosphere, and gradually melts in water. Lanthanum is soluble in hot water and acid and, although it is not ductile, it is slightly malleable. Lanthanum's resistivity is 5.70 × 10⁻⁶ Ωcm, and it becomes oxide (La₂O₃) when burned at 445°C or higher (refer to Dictionary of Physics and Chemistry).

With rare earth elements, it is generally said that compounds with the oxidation number 3 are stable, and lanthanum is also trivalent. Recently, research and development is being promoted for using lanthanum as an electronic material such as a metal gate and a high-dielectric material (high-k). Like this, lanthanum is a noticeable metal.

Lanthanum metal is a material in which high purification is difficult to achieve since it is easily oxidized in the refining process, and a high purity product thereof did not exist to date. In addition, if lanthanum metal is left in the atmosphere, there is a problem in that the handling thereof is difficult since it will become oxidized and discolored to a black color in a short period of time.

Meanwhile, thinning of a gate insulator film in the next-generation MOSFET is being demanded, but with the SiO₂ that has been conventionally used as the gate insulator film, the leak current will increase due to the tunnel effect, and normal operation is becoming difficult.

Thus, as substitutes for the above, HfO₂, ZrO₂, Al₂O₃, and La₂O₃ with high dielectric constant, high thermal stability and high energy barrier against the holes and electrons in the silicon are being proposed. Particularly, La₂O₃ is valued highly among the foregoing materials, and research reports regarding its use as a gate insulting film in the next-generation MOSFET have been made based on examinations of its electrical properties (refer to Non-patent Document 1 and Non-patent Document 3). But, the subject of research in these documents is a La₂O₃ film, and the documents do not refer to the properties and behavior of the La element.

Accordingly, it could be said that lanthanum (lanthanum oxide) is still in the research phase, but when studying the properties of lanthanum metal or lanthanum oxide or a composite oxide of lanthanum and another element, if lanthanum metal itself exists as a sputtering target material, it is easy to form a lanthanum thin film on a substrate. Thus, it will also be easy to study the behavior at the interface with the silicon substrate, and additionally study the properties of a high-dielectric gate insulator film or the like by forming a lanthanum compound, and there is also a significant advantage in that the freedom of the target as a product will increase.

Nevertheless, even if a lanthanum sputtering target is prepared, as described above, there is a problem in that it becomes oxidized in a short period of time (approximately 10 minutes) in the atmosphere. When an oxide film is formed on the target itself, the electrical conductivity will deteriorate and thereby cause defective sputtering. In addition, if the lanthanum sputtering target is left in the atmosphere for a long period of time, it reacts with the moisture in the air and becomes covered with white hydroxide powder, and ultimately becomes degraded, and it may even cause a problem of not allowing normal sputtering to be performed.

Thus, after the target is prepared, it is necessary to immediately take oxidation prevention measures such as vacuum packing or covering the target with fats and oils, but these processes entail considerably troublesome work. In light of the foregoing problems, the current status is that a target material made of the lanthanum element has not yet been put into practical application.

Meanwhile, proposals have also been made for using lanthanum aluminate (LaAlO₃) rather than lanthanum (lanthanum oxide) as the starting material (refer to Non-patent Document 2). This document describes that such lanthanum aluminate (LaAlO₃) is a material that is even more favorable than HfO₂ and HfSiO as high-k insulating films proposed for the next generation.

In the foregoing case, the process of deposition becomes a problem. In the document, it is described that the leakage current is smaller in high temperature deposition (deposition at 700°C) than in room temperature deposition, and further explains that the reason for this is that defects in the film are eliminated and the excess oxygen existing in LaAlO₃ is removed with higher temperature deposition.

Although the document does not specify the deposition process, since it explained high temperature (700°C) deposition, the process uses reactive gas. Since the formation of the high-k insulating film is subject to a high temperature deposition process, it is considered that the foregoing problems cannot be resolved. And, another proposal is using La₂Hf₂O₇ as the interface material of a gate dielectric material (refer to Patent Document 1). The Examples of Patent Document 1 adopt a method of growing this on the Si wafer based on the atomic layer deposition method or the electron beam epitaxy method with HfCl₄ and H₂O and as the chemical precursor. In this case also, the deposition method is a problem.

With the atomic layer deposition method or the electron beam epitaxy method using HfCl₄ and H₂O and as the chemical precursor, it is difficult to control the deposition and the efficiency is also inferior. If these processes are not performed sufficiently, there is a problem in that precise deposition cannot be performed on the substrate.

Deposition based on the sputtering method is a simple method, and yields significant advantages such as the deposition rate being fast and the control thereof being easy. However, research on obtaining a sputtering target from lanthanum metal or lanthanum oxide or a composite oxide of lanthanum and another element is insufficient, and a problem that an effective target has not yet been obtained occurs.

[Non-patent Document 1] Eisuke Tokunaga and 2 others, "Research on Oxide for Use in High-k Gate Insulating Film" The Institute of Electrical Engineers of Japan, Electronic Material Research Material, Vol.6-13, Pages 37-41, issued on September 21, 2001 [Non-patent Document 2] Masamichi Suzuki and 2 others, "Lanthanum Aluminate Direct-Bonded Gate Insulating Film" Toshiba Review, Vol.62, NO.2 (2007), Pages 37 to 41 [Non-patent Document 3] Written by ALSHAREEF H.N., QUEVEDO-LOPEZ M., WEN H.C., HARRIS R., KIRSCH P., MAJHI P., LEE B.H., JAMMY R., "Work function engineering using lanthanum oxide interfacial layers" Appl. Phys. Lett., Vol. 89 No 23 Pages 232103-232103-3, (2006) [Patent Document 1] Japanese Unexamined Patent Application Publication No. 2007-324593 US 2010/019357 discloses depositing of a Hf02-La 203 layer by sputtering.

### DISCLOSURE OF THE INVENTION

The present invention is defined in the claims. As described above, since metal lanthanum rapidly bonds with oxygen and decays, and lanthanum oxide bonds with moisture and forms a hydroxide and changes into powder form, there is a problem in that long-term storage is difficult and a sputtering target cannot be used for a practical use. In light of these points, an object of this invention is to provide a stable La-containing oxide sintered compact composed of oxides of lanthanum (La) and hafnium (Hf), and in particular provide a La-containing oxide sputtering target suitable for forming a high-k gate insulating film.

As described in the foregoing section, since metal lanthanum rapidly bonds with oxygen and decays, and lanthanum oxide bonds with moisture and forms a hydroxide, there is a problem in that long-term storage is difficult.

The present invention as defined in the claims obtains a sintered compact by adding hafnium oxide to lanthanum oxide, and further processing this sintered compact into a target for use in sputtering deposition. The component composition of this sintered compact and target includes new substances.

Based on the above, the present disclosure provides:
1) An oxide sintered compact composed of a composite oxide of lanthanum and hafnium, wherein the amount of hafnium contained in the sintered compact is equivalent or more relative to the lanthanum;
2) The oxide sintered compact according to 1) above, wherein the molar ratio of La:Hf in the oxide is 1:(1.0 to 1.2);
3) The oxide sintered compact according to 1) above, wherein the molar ratio of La:Hf in the oxide is 1:(1.01 to 1.1);
4) The oxide sintered compact according to any one of 1) to 3) above, wherein relative density is 98% or higher, maximum grain size is 50 µm or less, and average grain size is 5 µm or more and 20 µm or less;
5) The oxide sintered compact according to any one of 1) to 4) above, wherein alkali metals contained in the sintered compact are 40 ppm or less, transition metal elements excluding Zr are 100 ppm or less, Pb is 10 ppm or less, and U and Th are 5 ppb or less;
6) A sputtering target composed of the oxide sintered compact according to any one of 1) to 5) above; and
7) The sputtering target composed of the oxide sintered compact according to 5) above for use in forming a gate insulating film of a semiconductor device.

The present disclosure additionally provides:
8) A method of producing an oxide sintered compact of lanthanum and hafnium, wherein La₂(CO₃)₃ powder and HfO₂ powder are used as raw material powder, blending and mixing are performed so that the composition molar ratio of Hf and La becomes 1 to 1.2, the mixed powder is thereafter heated and synthesized in the atmosphere, the synthesized material is subsequently pulverized to obtain powder, and the synthesized powder is thereafter hot pressed into a sintered compact;
9) The method of producing the oxide sintered compact according to 8) above, wherein the molar ratio of La:Hf is 1:(1.01 to 1.1);
10) A method of producing an oxide sintered compact of lanthanum and hafnium, wherein La₂O₃ powder and HfO₂ powder are used as raw material powder, blending and mixing are performed so that the composition molar ratio of Hf and La becomes 1 to 1.2, the mixed powder is thereafter heated and synthesized in the atmosphere, the synthesized material is subsequently pulverized to obtain powder, and the synthesized powder is thereafter hot pressed into a sintered compact;
11) The method of producing the oxide sintered compact according to 10) above, wherein the molar ratio of La:Hf is 1:(1.01 to 1.1);
12) The method of producing the oxide sintered compact according to any one of 8) to 10) above, wherein the mixing is performed with a wet ball mill, and the synthesized powder is heated at 1350 to 1550°C for 5 to 25 hours in the atmosphere to obtain the sintered compact;
13) The method of producing the oxide sintered compact according to any one of 8) to 12) above, wherein the hot press is performed at 1300 to 1500°C in a vacuum for 1 to 5 hours;
14) The method of producing an oxide sintered compact, wherein the oxide sintered compact according to any one of 1) to 7) above is produced with the production method according to any one of 8) to 13) above; and
15) A method of producing an oxide sintered compact sputtering target according to the production method of 14 above.

### [Effect of the Invention]

A conventional lanthanum (lanthanum oxide) sputtering target had a problem in that normal sputtering cannot be performed when the lanthanum (lanthanum oxide) sputtering target is left out in the air for a long period of time and comes to react with moistures in the air and be covered with white hydroxide powder. However, the sintered compact and target of the present invention composed of oxides of lanthanum and hafnium are free from the foregoing problems, and can be stored for a long period of time that will not cause problems in terms of practical use.

Moreover, target of the present disclosure is a material that is particularly favourable as a gate insulating film, since it is used as a composite with Hf oxide which is generally used as a high-k material.

### BRIEF DESCRIPTION OF DRAWINGS

[Fig. 1] Fig. 1 is an external view (photograph) of a target obtained by bonding an oxide sintered compact of La₂Hf(₂.₀₄₄)O₇ to a Cu backing plate.
[Fig. 2] Fig. 2 is a micrograph showing the results upon observing the structure of the oxide sintered compact target of La₂Hf(₂.₀₄₄)O₇.
[Fig. 3] Fig. 3 is an external view (photograph) showing the results from the rain test of the mill ends of the oxide sintered compact of La₂Hf(₂.₀₄₄)O₇.
[Fig. 4] Fig. 4 is a diagram showing the results upon measuring the 2θ strength (CPS) of the mill ends before the rain test and 24 hours after the rain test of the oxide sintered compact of La₂Hf(₂.₀₄₄)O₇ based on X-ray diffraction (XRD).

La₂Hf₂O₇ as the stoichiometric component composition is normally stable and free from reaction with moisture. But, there are cases where a local La-excessive area is formed due to a slight fluctuation of the composition. In the foregoing case, the local oxidation or hydroxylation of La will advance, which is a problem that will considerably deteriorate the functions as a sintered compact or target.

Nevertheless, as with the present invention, if the amount of Hf is made to be equal to the ratio of the stoichiometric component composition, or added slightly excessively than the foregoing ratio, it is possible to prevent the generation of lanthanum oxide and the reaction with moisture. This yields a superior effect of being able to maintain the functions as a sintered compact or target for a long period of time. If the amount of Hf is made to be equal to the ratio of the stoichiometric component composition, the local formation of La oxide or La hydroxide can be inhibited by sufficiently performing the mixing and sintering of the components and eliminating the segregation of the components.

### BEST MODE FOR CARRYING OUT THE INVENTION

The oxide sintered compact or sputtering target of the present invention is a sintered compact or sputtering target composed of the oxides of lanthanum (La) and hafnium (Hf), and is characterized in that the hafnium contained in the sintered compact or sputtering target is equivalent or more relative to the lanthanum.

Moreover, the ratio of La:Hf in the oxide; that is, La:Hf = 1:(1.0 to 1.2), and preferably La:Hf = 1:(1.01 to 1.1).

The stoichiometric composition of the oxides of lanthanum (La) and hafnium (Hf) is La₂Hf₂O₇ as described above. As evident from this composition ratio, there are areas where Hf is excessive in comparison to the stoichiometric composition ratio. Specifically, La:Hf = 1:x(1.0 ≤ x ≤ 1.2). If x is less than 1.0, the durability against moisture will considerably deteriorate. Thus, the lower limit of x needs to be 1.0. Moreover, if x is greater than 1.2, since the characteristics will approach HfO₂, it is considered that the characteristics will not improve even when combined with a high-k material. Thus, the upper limit of x was set to 1.2. Further recommended condition is x = 1.01 to 1.1.

Upon producing this oxide sintered compact target, La₂(CO₃)₃ powder or La₂O₃ powder and HfO₂ powder are preferably used as the raw material powders. Moreover, these are blended so that the molar ratio of Hf and La becomes 1.0 to 1.2, preferably so that the molar ratio of Hf and La becomes 1.01 to 1.1.

The La raw material powder is not limited to the foregoing raw material powder if it can be oxidized in advance based on heat treatment. For example, as such raw materials, there are lanthanum hydroxide, lanthanum nitrate, lanthanum chloride and the like. Moreover, metal lanthanum may also be used. After mixing the foregoing powders, they are heated and synthesized in an oxygen atmosphere, the synthesized material is subsequently pulverized to obtain powder, and the synthesized powder is further hot pressed to obtain a sintered compact.

The recommended production conditions are to perform the mixing using a wet ball mill, and to perform the synthesis by heating the powder at 1350 to 1550°C for 5 to 25 hours in the atmosphere.

Moreover, to perform the hot press at 1300 to 1500°C in a vacuum for 1 to 5 hours is also the recommended production conditions as the sintering conditions. The foregoing conditions are for efficiently performing the synthesis and sintering. Accordingly, it should be understood that the adoption of other conditions and the addition of other conditions can be performed as a matter of course.

The mixing, synthesis and sintering of the foregoing powders are conditions for obtaining a uniform structure without any segregation of the La composition, and a dense sintered compact and target can thereby be obtained.

If there is excessive La oxide or La hydroxide, the sintered compact or target will decay and considerably shorten the life as a product. In that case, by increasing the amount of Hf to be slightly more than the La₂Hf₂O₇ stoichiometric component composition ratio, the decay of the sintered compact or target can be avoided even if there is such fluctuation (segregation) of the component.

This is because, even if there is local fluctuation of the composition, the excessive segregation of La is inhibited due to the excessive existence of Hf, and a stable LaHf oxide can be retained in the sintered compact or target. The addition of slightly excessive Hf than the stoichiometric component composition ratio is a preferred condition for producing a stable sintered compact or target. It is thereby possible to obtain an oxide sintered compact with a relative density of 98% or higher and maximum grain size of 50 µm or less, and further process this to obtain a sputtering target.

The improvement of density and the refinement of crystal grain size are able to inhibit the generation of nodules and particles, and are preferred conditions for performing uniform deposition.

Conventionally, there are documents related to thin films using La metal, La oxide or composite oxide of La and another element, but they are all based on the gas phase reaction of the atomic layer deposition method or the electron beam epitaxy method with HfCl₄ and H₂O and as the chemical precursor, and do not provide any kind of proposal as a sintered compact or a sputtering target.

The reason for this is considered to be that, in the production process of a sintered compact or target composed of La metal, La oxide or composite oxide of La and another element, the La metal, La oxide or composite oxide of La and another element rapidly decays and is unable to maintain its shape.

Nevertheless, the present invention is based on the discovery that, by adding Hf and adjusting the components, and further controlling the mixture, blending and sintering conditions of the raw material powders, it is possible to inhibit the decay of a La-containing composite oxide sintered compact or target, and thereby enables the use as a sputtering target. Moreover, the addition of Hf is also advantageous as a high-k material as described above.

Generally speaking, the rare earth elements contained in lanthanum include Sc, Y, Ce, Pr, Nd, Pm, Sm, Eu, Gd, Tb, Dy, Ho, Er, Tm, Yb, and Lu other than lanthanum (La), but it is difficult to separate and refine these elements from La since they have similar properties. In particular, since Ce is approximate to La, it is said that it is difficult to reduce Ce.

Nevertheless, since these rare earth elements have approximate properties, it should be understood there is no particular problem so as long as the total amount of rare earth elements is less than 1000 wtppm. Accordingly, although the inclusion of rare earth elements at the foregoing level is tolerated, the reduction thereof would be preferable in order to leverage the characteristics of La as the gate insulating film.

Besides the above, there are unavoidable impurities that get mixed in. The analytical values are shown in Table 1. Although Zr is contained in a large amount (1600 wtppm), there is no particular problem even if Zr exists as an impurity, since fortunately Zr has very approximate chemical properties as Hf when added intentionally in the present invention. Nevertheless, in order to clearly leverage the characteristics of Hf, it could be said that the further reduction of Zr is a preferred condition. The present invention covers all of the foregoing cases.

**Analytical Value of Unavoidable Impurity (unit:wt ppm)**

| | | | | | | | | | | |
|---|---|---|---|---|---|---|---|---|---|---|
| Li | 0.81 | | Fe | 16 | | Cd | <1 | | Tm | 0.39 |
| Be | <0.01 | | Co | 0.33 | | In | Binder | | Yb | 0.57 |
| B | 2.1 | | Ni | 2.3 | | Sn | 0.93 | | Lu | 0.59 |
| O | Matrix | | Cu | 1.6 | | Sb | <0.5 | | Hf | Matrix |
| F | 2.5 | | Zn | 3.6 | | Te | <5 | | Ta | Source |
| Na | 15 | | Ga | <0.1 | | I | <1 | | w | 15 |
| Mg | 0.81 | | Ge | <0.5 | | Cs | <5 | | Re | <0.1 |
| Al | 20 | | As | <0.5 | | Ba | <1 | | Os | <0.05 |
| Si | 17 | | Se | <5 | | La | Matrix | | Ir | <0.1 |
| p | 0.72 | | Br | <5 | | Ce | 415 | | Pt | <1 |
| s | 1.6 | | Rb | <5 | | Pr | 110 | | Au | <1 |
| Cl | 5.7 | | Sr | 0.65 | | Nd | 155 | | Hg | <0.5 |
| K | 3.9 | | Y | 29 | | Sm | 2.1 | | Tl | <0.1 |
| Ca | 4.8 | | Zr | 1600 | | Eu | 0.06 | | Pb | <1 |
| Sc | 0.61 | | Nb | 0.08 | | Gd | 3.1 | | Bi | <0.1 |
| Ti | 2.6 | | Mo | 6.8 | | Tb | 0.25 | | Th | <0.005 |
| V | 0.11 | | Ru | 0.33 | | Dy | 2.5 | | u | <0.005 |
| Cr | 5 | | Rh | <0.1 | | Ho | 1.5 | | | |
| Mn | 0.31 | | Pd | 4.1 | | Er | <0.05 | | | |
| | | | | | | | | | | |
| | | | | | | | | | | |
| C | 18 | | | | | | | | | |
| H | 5.8 | | | | | | | | | |

Generally, C, N, O, S, and H exist as gas components. Oxygen can be fixed as a harmful component as described above, but the other gas components do not cause any particular problem. These gas components may exist as independent elements, but in many cases they exist as compounds (CO, CO₂, SO₂ and so on) or sometimes exist in the form of compounds with the constituent elements. Since these gas component elements have a small atomic weight and atomic radius, so as long as they are not contained in large amounts, they will hardly affect the properties of the material even when existing as impurities. Accordingly, the purity of lanthanum of the present invention is preferably 3N or higher excluding rare earth elements, Zr, and gas components.

Moreover, preferably, the alkali metals contained in the sintered compact is 40 ppm or less, transition metal elements excluding Zr are 100 ppm or less, Pb is 5 ppm or less, and U and Th are 5 ppb or less. Since these deteriorate the characteristic of the semiconductor material, it is preferable to reduce them as much as possible. In particular, this is because alkali metals easily move into the gate insulating film and deteriorate the MOS interface properties, the damage caused by the alpha rays emitted from the radioactive elements affect the operational reliability of the MOS devices, and transition metal elements such as Fe and Ni and heavy metal elements cause trouble at the interface bonding part.

In addition, based on the foregoing production conditions, the present invention is to achieve an oxide sintered compact with a relative density of 98% or higher, maximum grain size of 50 µm or less, and average grain size of 5 µm or more and 20 µm or less. It is thereby possible to prevent the generation of particles during sputtering, and form a film with superior uniformity.

As a result of performing sputtering with the foregoing target, it is possible to form a gate insulating film made of oxides of lanthanum and hafnium with a component composition of La₂Hf(_{2.0-2}.₄)O₇ (ratio of La:Hf is 1:(1.0 to 1.2)), preferably La₂Hf(₂.₀₂₋₂.₂)O₇ (ratio of La:Hf is 1:(1.01 to 1.1)) (hereinafter referred to as the "basic component composition La₂Hf₂O₇"). The component composition of the target is directly reflected in the deposition.

Moreover, after forming the gate insulating film composed of the oxides of lanthanum and hafnium of the basic component composition La₂Hf₂O₇, heat treatment may be performed thereto at 50 to 300°C. This aims to further fix the free oxygen existing in the film, and is a condition that can be additionally performed. It should be understood that this condition is not essential. In particular, this is an unnecessary condition in the production conditions of a next-generation MOSFET or the like which such heating is undesirable.

### [Examples]

Examples of the present invention are now explained. Incidentally, these Examples are merely for facilitating the understanding of the invention, and the present invention shall in no way be limited thereby. In other words, various modifications and other embodiments based on the technical spirit claimed in the claims shall be covered by the present invention as a matter of course.

### (Example 1)

La₂(CO₃)₃ powder and HfO₂ powder were used as raw material powders and blended so that the composition molar ratio of Hf and La became 1:1.03, and mixed with a wet ball mill for 3 hours. The mixed powder was further heated and synthesized in the atmosphere at 1450°C for 20 hours. Moreover, the synthesized material was subject to wet grinding with a ball mill for 10 hours to obtain powder. Consequently, synthesized powder with a component composition of La₂Hf₂.₀₄₄O₇ was obtained. The synthesized powder was hot pressed at 1500°C for 2 hours to obtain a sintered compact. The size of the sintered compact was an inner diameter of φ 190 mm, and the working pressure was 300 kg/cm².

Consequently, an oxide sintered compact with a component composition of La₂Hf₂.₀₄₄O₇ was obtained. This was further machined to obtain a sputtering target. The size of the machined target was an inner diameter of φ 164 mm x 6 mmt. Moreover, the relative density of the target was 99.75% (7.934 g/cm³: logical density was 7.954 g/cm³).

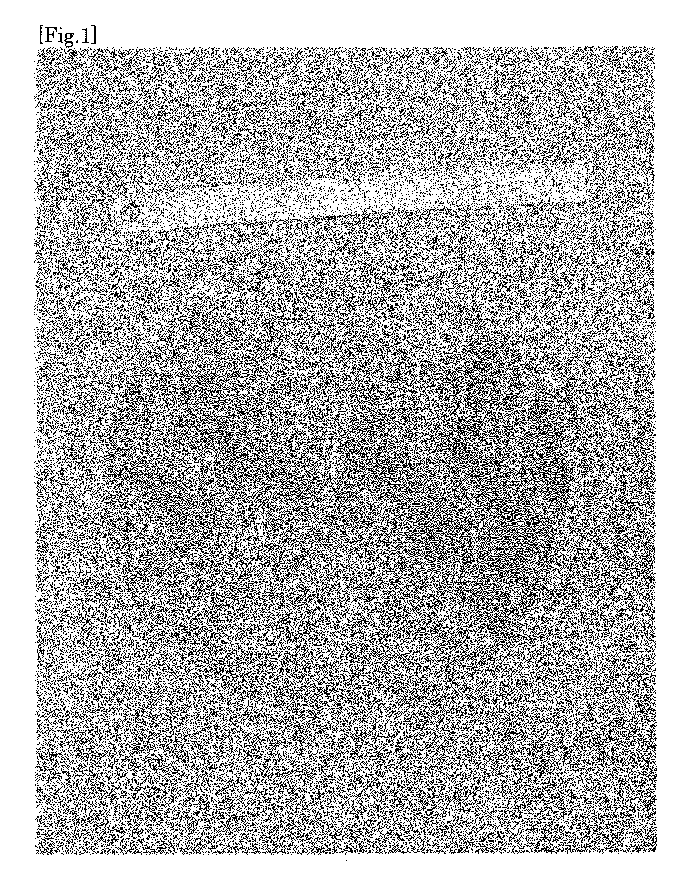

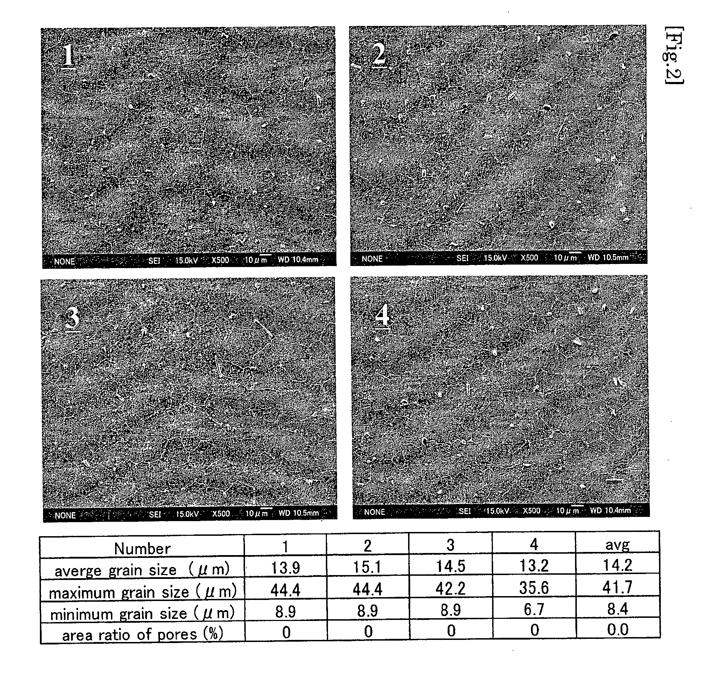

This target was further bonded to a Cu backing plate in the atmosphere. The appearance of the target bonded to the Cu backing plate is shown in Fig. 1. Moreover, the results upon observing the target structure are shown in Fig. 2. Fig. 2 shows the results upon randomly extracting 4 locations on the target surface. As shown in Fig. 2, average grain size was 13.2 to 15.1 µm, maximum grain size was 35.6 to 44.4 µm, minimum grain size was 6.7 µm, area ratio of pores is approximately 0%, and it has been confirmed that a high density and fine structure was obtained.

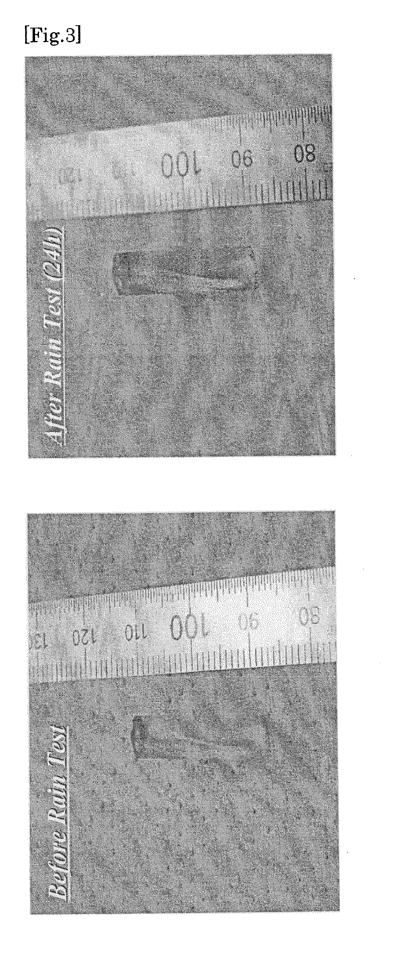

The results from the rain test of the mill ends of the oxide sintered compact prepared as described above with a component composition of La₂Hf₂.₀₄₄O₇ are shown in Fig. 3. Fig. 3 shows the results before the rain test on the left and shows the results 24 hours after the rain test on the right. As shown in Fig. 3, there was no trace of corrosion caused by oxidation or hydroxylation even 24 hours after the rain test.

Normally, if lanthanum (lanthanum oxide) left out in the atmosphere even for 1 hour, corrosion caused by oxidation or hydroxylation advances rapidly and discoloration, initially white and then black, can be observed, but no corrosion was observed in the oxide sintered compact of La₂Hf₂.₀₄₄O₇.

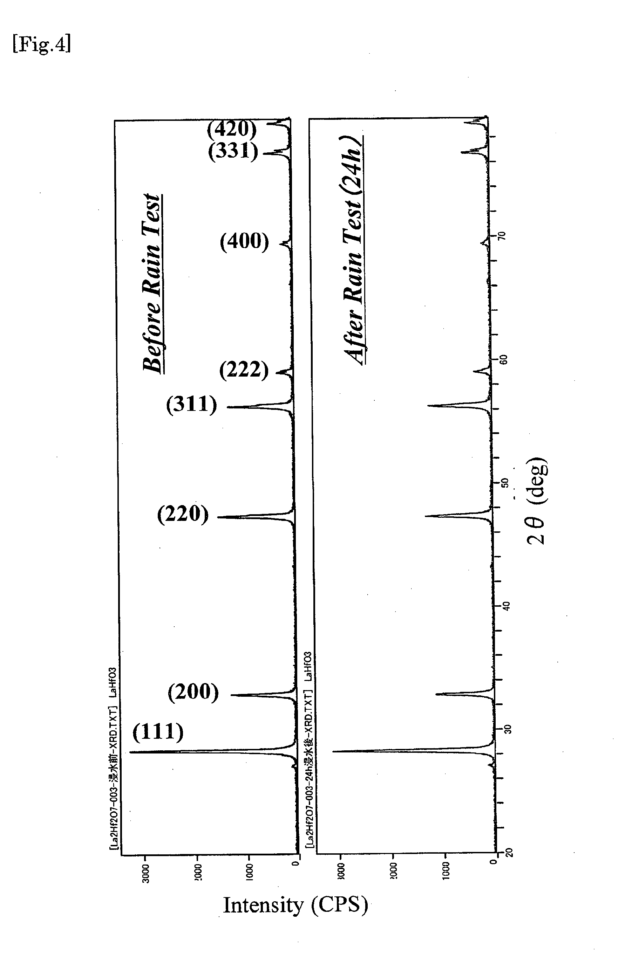

Moreover, in order to evaluate this, the 2θ strength (CPS) of the mill ends was measured before the rain test and 24 hours after the rain test of the oxide sintered compact of La₂Hf(₂.₀₄₄)O₇ based on X-ray diffraction (XRD). The results are shown in Fig. 4. As shown in Fig. 4, the mill ends did not change before the rain test and 24 hours after the rain test. Based on this evaluation, it was once again confirmed that corrosion caused by oxidation or hydroxylation did not advance.

In addition, RF sputtering was performed with this target to form a thin oxide film of La₂Hf₂.₀₄₄O₇ on the Si substrate. Consequently, no Si oxide film layer was observed at the interface of Si and the thin oxide film of La₂Hf₂.₀₄₄O₇. This shows that it is effective as a gate insulating film material.

Note that, although Example 1 used La₂(CO₃)₃ powder as the raw material powder, the same results were obtained when La₂O₃ powder was used. There was no particular problem in selecting the raw material powder containing La.

### (Example 2 to Example 8)

La₂(CO₃)₃ powder and HfO₂ powder were used as the raw material powders and blended so that the molar ratio of Hf and La became as follows; namely, Hf was 1.01, 1.02, 1.04, 1.05, 1.06, 1.08, and 1.2, respectively, while La was 1, and mixed with a wet ball mill. The production conditions were the same as Example 1. Consequently, the same results as Example 1 were obtained.

So as long as the molar ratio of Hf is maintained to be at least 1.0 or more relative to La, there is no particular influence of corrosion. However, if the molar ratio of Hf exceeds 1.2, the characteristics of La as a gate insulating film tend to deteriorate, and it is necessary to set the upper limit of the molar ratio of Hf to be 1.2.

### INDUSTRIAL APPLICABILITY

A conventional lanthanum (lanthanum oxide) sputtering target had a problem in that normal sputtering cannot be performed, when the lanthanum (lanthanum oxide) sputtering target is left out in the air for a long period of time and comes to react with moistures in the air and be covered with white hydroxide powder. However, the sintered compact and target of the present invention composed of oxides of lanthanum and hafnium are free from the foregoing problems.

Moreover, since the amount of Hf is equal to or greater than La₂Hf₂O₇ as a stoichiometric component composition, the free oxygen or excess oxygen contained in the composite oxide of lanthanum and hafnium can be fixed to Hf with stronger oxidizing power, and a significant effect is yielded in that the free oxygen will move into the La₂Hf₂O₇ film that was subject to sputtering deposition, and react at the Si interface and prevent the formation of harmful SiO₂.

Thus, performing deposition using this target yields a significant effect in forming a uniform film, and the formed thin film is useful as an electronic material disposed in the vicinity of the silicon substrate, particularly as a gate insulating film material, without deteriorating and disturbing the functions of electronic devices.

## Claims

1. A sputtering target composed of an oxide sintered compact composed of a composite oxide of lanthanum and hafnium obtained by sintering lanthanum oxide or lanthanum carbonate, and hafnium oxide, wherein the amount of hafnium contained in the sintered compact is equivalent or more relative to the lanthanum; wherein the molar ratio of La:Hf in the oxide is 1:(1.01 to 1.1).

2. The sputtering target composed of the oxide sintered compact according to claim 1, wherein relative density is 98% or higher, maximum grain size is 50 µm or less, and average grain size is 5 µm or more and 20 µm or less.

3. The sputtering target composed of the oxide sintered compact according to any one of claims 1 or 2, wherein alkali metals contained in the sintered compact are 40 ppm or less, transition metal elements excluding Zr are 100 ppm or less, Pb is 10 ppm or less, and U and Th are 5 ppb or less.

4. The sputtering target composed of the oxide sintered compact according to claim 3 for use in forming a gate insulating film of a semiconductor device.

5. A method of producing a sputtering target composed of an oxide sintered compact of lanthanum and hafnium, wherein La₂(CO₃)₃ powder or La₂(CO₃)₃ powder and HfO₂ powder are used as raw material powder, blending and mixing are performed so that the composition molar ratio of La:Hf becomes 1:(1.01 to 1.1), the mixed powder is thereafter heated and synthesized in the atmosphere, the synthesized material is subsequently pulverized to obtain powder, and the synthesized powder is thereafter hot pressed into a sintered compact.

6. The method of producing a sputtering target composed of an oxide sintered compact of lanthanum and hafnium according to claim 5 wherein the method produces the sputtering target according to any one of claims 1 to 3.

7. The method of producing the sputtering target composed of the oxide sintered compact according to any one of claims 5 or 6, wherein the mixing is performed with a wet ball mill, and the synthesized powder is heated at 1350 to 1550°C for 5 to 25 hours in the atmosphere to obtain the sintered compact.

8. The method of producing the sputtering target composed of the oxide sintered compact according to any one of claims 5 to 7, wherein the hot press of the synthesized powder is performed at 1300 to 1500°C in a vacuum for 1 to 5 hours.

## Patentansprüche

1. Sputtering-Target, bestehend aus einem gesinterten Objekt auf Oxidbasis, das aus einem Verbundoxid aus Lanthan und Hafnium besteht, das durch Sintern von Lanthanoxid oder Lanthankarbonat, und Hafniumoxid, gewonnen wird, wobei die im gesinterten Objekt enthaltene Menge Hafnium dem Lanthan äquivalent ist oder eher entspricht; wobei das molare Verhältnis von La:Hf im Oxid 1:(1,01 bis 1,1) lautet.

2. Sputtering-Target, bestehend aus dem gesinterten Objekt auf Oxidbasis nach Anspruch 1, wobei die relative Dichte 98 % oder höher ist, die maximale Korngröße 50 µm oder weniger ist und die durchschnittliche Korngröße 5 µm oder mehr und 20 µm oder weniger ist.

3. Sputtering-Target, bestehend aus dem gesinterten Objekt auf Oxidbasis nach einem beliebigen der Ansprüche 1 oder 2, wobei im gesinterten Objekt enthaltene Alkalimetalle 40 ppm oder weniger sind, Übergangsmetallelemente ausschließlich Zr 100 ppm oder weniger sind, Pb 10 ppm oder weniger ist und U und Th 5 ppb oder weniger sind.

4. Sputtering-Target, bestehend aus dem gesinterten Objekt auf Oxidbasis nach Anspruch 3, zur Verwendung bei der Bildung eines Gate-Isolierfilms eines Halbleiterbauelements.

5. Verfahren zur Herstellung eines Sputtering-Targets, bestehend aus einem gesinterten Objekt auf Oxidbasis aus Lanthan und Hafnium, wobei La₂(CO₃)₃-Pulver oder La₂(CO₃)₃-Pulver und HfO₂-Pulver als Rohstoffpulver verwendet werden, das Dosieren und das Mischen so durchgeführt werden, dass das molare Verhältnis der Zusammensetzung von La:Hf 1:(1,01 bis 1,1) wird, das gemischte Pulver danach an der Atmosphäre erhitzt und synthetisiert wird, das synthetisierte Material folglich pulverisiert wird, um Pulver zu erhalten, und das synthetisierte Pulver danach zu einem gesinterten Objekt heißgepresst wird.

6. Verfahren zur Herstellung eines Sputtering-Targets, das aus einem gesinterten Objekt auf Oxidbasis aus Lanthan und Hafnium nach Anspruch 5 besteht, wobei das Verfahren das Sputtering-Target nach einem beliebigen der Ansprüche 1 bis 3 erzeugt.

7. Verfahren zur Herstellung eines Sputtering-Targets, das aus dem gesinterten Objekt auf Oxidbasis nach einem beliebigen der Ansprüche 5 oder 6 besteht, wobei das Mischen mit einer Nasskugelmühle durchgeführt wird und das synthetisierte Pulver 5 bis 25 Stunden lang an der Atmosphäre auf 1350 bis 1550 °C erhitzt wird, um das gesinterte Objekt zu erhalten.

8. Verfahren zur Herstellung eines Sputtering-Targets, das aus dem gesinterten Objekt auf Oxidbasis nach einem beliebigen der Ansprüche 5 bis 7 besteht, wobei das Heißpressen des synthetisierten Pulvers 1 bis 5 Stunden lang bei 1300 bis 1500 °C in einem Vakuum durchgeführt wird.

## Revendications

1. Cible de pulvérisation composée d'une pièce frittée d'oxyde composée d'un oxyde composite de lanthane et de hafnium obtenu en frittant de l'oxyde de lanthane et du carbonate de lanthane, et de l'oxyde de hafnium, dans laquelle la quantité de hafnium contenue dans la pièce frittée est au moins équivalente à celle du lanthane, le rapport molaire La:Hf dans l'oxyde étant de 1:(1,01 à 1,1).

2. Cible de pulvérisation composée de la pièce frittée d'oxyde selon la revendication 1, dans laquelle la densité relative est supérieure ou égale à 98 %, la granulométrie maximale est inférieure ou égale à 50 µm, et la granulométrie moyenne est supérieure ou égale à 5 µm ou inférieure ou égale à 20 µm.

3. Cible de pulvérisation composée de la pièce frittée d'oxyde selon l'une quelconque des revendications 1 ou 2, dans laquelle les métaux alcalins contenus dans la pièce frittée sont inférieurs ou égaux à 40 ppm, les éléments métalliques de transition à l'exception du Zr sont inférieurs ou égaux à 100 ppm, le Pb est inférieur ou égal à 10 ppm, et l'U et le Th sont inférieurs ou égaux à 5 ppb.

4. Cible de pulvérisation composée de la pièce frittée d'oxyde selon la revendication 3, destinée à être utilisée dans la formation d'une couche d'isolation de grille d'un dispositif à semi-conducteur.

5. Procédé de production d'une cible de pulvérisation composée d'une pièce frittée d'oxyde de lanthane et de hafnium, dans lequel de la poudre de La2(CO3)3 ou de la poudre de La2(CO3)3 et de la poudre de Hf02 sont utilisées comme matière première en poudre, l'homogénéisation et le mélange sont réalisés de telle sorte que le rapport molaire La:Hf de la composition devienne 1:(1,01 à 1,1), la poudre mélangée est ensuite chauffée et synthétisée dans l'atmosphère, le matériau synthétisé est ensuite pulvérisé afin d'obtenir une poudre, et la poudre synthétisée est ensuite comprimée à chaud sous forme de pièce frittée.

6. Procédé de production d'une cible de pulvérisation composée d'une pièce frittée d'oxyde de lanthane et de hafnium selon la revendication 5, le procédé produisant la cible de pulvérisation selon l'une quelconque des revendications 1 à 3.

7. Procédé de production d'une cible de pulvérisation composée de la pièce frittée d'oxyde selon l'une quelconque des revendications 5 ou 6, dans lequel le mélange est réalisé avec un broyeur à boulets à l'état humide, et la poudre synthétisée est chauffée entre 1350 et 1550 °C pendant 5 à 25 heures dans l'atmosphère afin d'obtenir la pièce frittée.

8. Procédé de production d'une cible de pulvérisation composée de la pièce frittée d'oxyde selon l'une quelconque des revendications 5 à 7, dans lequel la compression à chaud de la poudre synthétisée est réalisée entre 1300 et 1500 °C sous vide pendant 1 à 5 heures.
